Europäisches Patentamt

European Patent Office

Office européen des brevets

(19)

(11) **EP 1 596 498 A2**

(12) **EUROPEAN PATENT APPLICATION**

(43) Date of publication:
**16.11.2005 Bulletin 2005/46**

(51) Int Cl.7: **H03K 17/691**

(21) Application number: **05252729.8**

(22) Date of filing: **03.05.2005**

(84) Designated Contracting States:
**AT BE BG CH CY CZ DE DK EE ES FI FR GB GR
HU IE IS IT LI LT LU MC NL PL PT RO SE SI SK TR**
Designated Extension States:
**AL BA HR LV MK YU**

(30) Priority: **14.05.2004 GB 0410837**

(71) Applicant: **Goodrich Control Systems Ltd
Solihull, West Midlands B90 4LA (GB)**

(72) Inventor: **Turvey, Simon
Birmingham, B28 0LS (GB)**

(74) Representative: **Beck, Simon Antony et al
Withers & Rogers LLP
Goldings House,
2 Hays Lane
London SE1 2HW (GB)**

(54)    **Compensation circuit and drive circuit including such a compensation circuit**

(57)    A compensation circuit is provided for use in a drive arrangement for an isolation transformer in series with a capacitor. The compensation circuit applies a compensation voltage to the capacitor such that the voltage across the capacitor remains substantially invariant.

Fig. 3

EP 1 596 498 A2

## Description

FIELD OF THE INVENTION

The present invention relates to a compensation circuit and to a drive circuit including such a compensation circuit.

BACKGROUND OF THE INVENTION

It is often useful to be able to provide a drive signal from a control system to a device via an isolating circuit. The isolating circuit typically allows a control system, which might be a microprocessor or similar running at a relatively low voltage to interface with a load device, such as an actuator, which typically is driven from a relatively high voltage power supply. It may be desirable for safety and operational reasons to ensure that the control system and the drive device are electrically isolated from one another at least from a DC standpoint.

It is also desirable that the drive signal can in fact be used to transfer power to some of the signal processing circuits which receive the drive signal. This supply of power is also isolated by the transformer. This may be particularly advantageous where the controlled device presents a large and/or fluctuating load. For example an electric motor may present such a load, and it may give rise to significant voltage fluctuations, especially if the motor becomes heavily loaded or is back driven. This might in turn cause control circuitry to behave unpredictably if such circuitry also derived its supply from the power supply to the motor. However if some of the control circuitry associated with the motor derives its power supply from another source, such as from the drive signal, then it becomes possible to ensure that the power supply is "cleaner" (less noisy).

Isolating couplings such as opto-couplers provide isolation, but do not provide full power transfer in order to drive the detection circuits. Therefore isolation transformers remain the favoured isolating coupling.

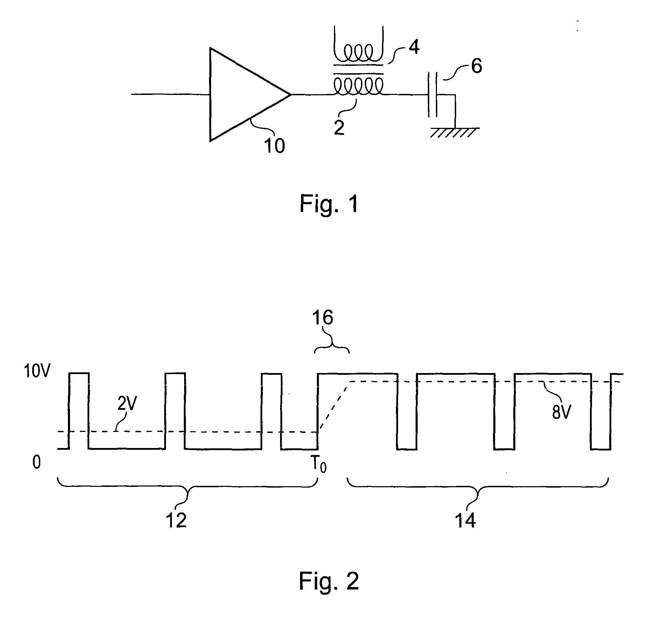

A problem with isolation transformers is that if the drive signal contains a DC component, either because the drive signal includes a DC voltage or alternatively is, for example, a pulse width modulated waveform with a duty cycle other than 50-50, then the DC component will flow through the primary winding of the isolation transformer and the DC component may cause the magnetic core of the isolation transformer to go into saturation. This then significantly impairs the transformer's coupling efficiency. In order to overcome this, prior art drive arrangement as shown in Figure 1, place the primary winding 2 of the transformer 4 in series with a DC blocking capacitor 6. Whilst this solution overcomes the saturation problem, it does give rise to a transitional period which may be sufficiently long to mask the information being transferred across the isolating transformer when the duty cycle of the waveform is changed whilst the capacitor charges or discharges.

US 6,144,193 discloses a drive arrangement in which the problems of build up of a charge on the capacitor have been identified. The solution proposed in US 6,144,193 is to increase the turns ratio of the secondary winding of the transformer and to introduce a non-linear load such as clipping diodes as shown in Figure 4 of that patent. However these are believed to be disadvantageous as they may give rise to "ringing" at a resonant frequency formed by the inductance of the secondary winding and the capacitance of the diodes.

SUMMARY OF THE INVENTION

According to a first aspect of the present invention there is provided a compensation circuit for use with an isolation device comprising an isolation transformer in series with a capacitor, and wherein the isolation device is driven with a drive signal which encodes first and second states, and in the first state the drive signal has a first average value and in the second state the drive signal has a second average value, the compensation circuit comprising a compensation voltage generator for generating a compensation voltage for supply to the isolation device or addition to drive signal so as to hold a DC component of voltage across the capacitor substantially constant.

It is thus possible to provide the compensation circuit which seeks to maintain the voltage across the DC blocking capacitor substantially invariant. This effectively eliminates or substantially reduces the transitional period which is found in prior art circuits and which may mask the transfer of information across the isolating transformer.

Advantageously the drive signal is a pulse width modulated signal which can take first and second pulse trains. The mark-space ratios of the first and second pulse trains are predetermined and hence the time averaged DC voltage of each of the pulse trains can be easily determined. The compensation circuit can then provide a voltage change equal to the difference between the time average DC voltage of the first and second pulse trains in order to hold the voltage across the capacitor substantially invariant.

The compensation circuit may output a compensation voltage which can be added to the drive signal supplied to the transformer. Thus the correction voltage can be supplied to a transformer which is driven in a single ended manner. However, preferably, the compensation voltage is applied to a side of the transformer winding opposed to the side which receives the drive signal. Thus the transformer is effectively driven in a dual ended manner.

Advantageously the compensation voltage varies as a function of an input signal which the drive circuit is seeking to encode. Therefore the compensation circuit can be driven directly from the input signal.

In a preferred embodiment of the invention there is provided a driver for an isolation device, where the isolation device has first and second input terminals, the driver comprising:

a first drive device coupled to the first input terminal of the isolation device;
a second drive device coupled to the second input terminal of the isolation device; and
a signal input for receiving a signal having first and second input signal states;

where:

in the first input signal state the first drive device outputs a first pulse train having a first average voltage and the second drive device outputs a first voltage; and
in the second input signal state the first drive device outputs a second pulse train having a second average voltage, and the second device outputs a second voltage, and the first and second voltages are selected such that the average voltage across the isolation device in the first input signal state substantially matches an average voltage across the isolation device in the second input signal state.

According to a second aspect of the present invention there is provided a drive for an isolating device, where the isolating device has first and second input terminals and comprises an isolation transformer in series with a capacitor, wherein the drive includes a drive device coupled to an input of the isolating device for providing the drive signal, and wherein the driver further includes a compensation circuit for holding a DC voltage across the isolating device substantially constant.

According to a third aspect of the present invention, there is provided a method of maintaining a DC voltage across a DC blocking capacitor substantially constant, where the DC blocking capacitor is in series with an isolation transformer and where the isolation transformer is driven with a drive signal that encodes at least first and second states, and in the first state the drive signal has a first average value and in the second state the drive signal has a second average value, the method comprising generating a compensation voltage for supplying to the isolation device or for addition to the drive signal so as to hold a DC component of voltage across the capacitor substantially constant.

## BRIEF DESCRIPTION OF THE DRAWINGS

The present invention will further be described, by way of example, with reference to the accompanying drawings in which:

Figure 1 schematically illustrates a prior art drive circuit for an isolation transformer;

Figure 2 is a graph showing a pulse train applied to the drive circuit of Figure 1 and also showing how the DC voltage stored on the capacitor 6 varies with the pulse train;

Figure 3 schematically illustrates a drive circuit including a compensation circuit constituting an embodiment of the present invention;

Figures 4a and 4b schematically illustrate exemplary pulse trains applied by the drive circuit to the isolation transformer; and

Figure 5 is a schematic diagram of the signal processing circuits, in block element form, situated on the down stream side of the isolation transformer.

## DESCRIPTION OF PREFERRED EMBODIMENTS OF THE INVENTION

As shown in Figure 1, prior art arrangements typically have a driver circuit 10 whose output is connected to a first terminal of a primary winding 2 of the isolation transformer 4. A second terminal of the primary winding is connected to ground via a DC blocking capacitor 6. As noted before this is necessary to stop the transformer core saturating. The transformer and capacitor form an isolation device having first and second terminals.

Figure 2 schematically illustrates a pulse train which is used to encode information to be transferred across the isolation transformer 4. In the time period preceding To a pulse train has a mark to space ratio of 20-80, therefore meaning that the mark period occupies $\frac{20}{(20 + 80)}$ = 20% of the duty cycle. This time period is designated 12 in Figure 2.

It can be seen that, if the pulse train were to transit between 0 volts and 10 volts, then the effective power delivered by the pulse train in the period 12 would be equivalent to that delivered by a constant 2 volt supply. It therefore follows that during the period 12 the DC voltage that builds across the capacitor 6 is 2 volts (or 20% of the pulse train amplitude). In a second period, designated 14, the pulse train has a mark-space ratio of 80-20. Therefore the signal is asserted for $\frac{80}{(80+20)}$ = 80% of the time. Once again, it can be seen that if the pulse train transits between 0 and 10 volts, then the power delivered by this pulse train is equivalent to the power delivered by an 8 volt DC supply. Therefore in the period 14 the average voltage across the capacitor is 8 volts.

The capacitor discharges and charges through the resistance of the primary winding 2. As a result, when a transition in the pulse train occurs at time To the voltage across the capacitor 6 cannot change instantaneously. Therefore the capacitor has to charge through the resistance of the primary winding 2 and the internal resistance of the driver circuit 10. This gives rise to a period 16 during which the voltage across the capacitor is in transition. In Figure 2 the transition period 16 has, for convenience, been drawn as being much shorter than one period of the pulse train. However there is no intrinsic reason why this should be the case. Therefore the use of a rapid switching frequency for the pulse train and/or a capacitor and primary winding resistance combination whose time constant is similar to or longer than the period of a pulse train will give rise to a transitional period which masks the information being sent across the isolation transformer. The inventor has realised that this transitional period can be effectively eliminated by applying a correction voltage.

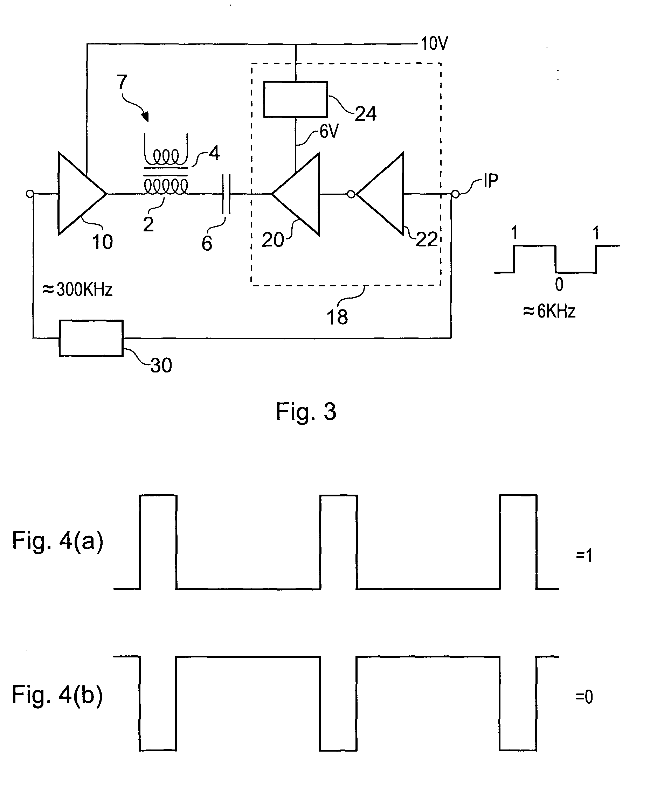

From the analysis given with respect to Figures 1 and 2, it can be seen that the size of the voltage change across the capacitor can be deduced from knowledge of the mark-space ratio and the peak to peak magnitude of the pulse train. Therefore given knowledge of which pulse sequence is being applied to the isolation transformer it becomes possible to make an open loop voltage correction which ensures that the voltage difference across the transformer remains substantially invariant. An example of a circuit capable of doing this is shown in Figure 3. The arrangement shown in Figure 3 is similar to that shown in Figure 1 in that a buffer 10 is connected to a first terminal of the primary winding 2 of an isolation transformer 4 and a second terminal of the primary winding 2 is connected in series with the capacitor 6. The transformer 4 and capacitor 6 together form an isolation device, generally designated 7. However, rather than having the second terminal of the isolation device connected to ground, the capacitor is now connected to the output of a compensation circuit, generally designated 18. The compensation circuit comprises a buffer 20 which receives its power from a voltage regulator 24. In this example the buffer 20 is driven by an inverter 22 which receives a copy of the logic signal that is subsequently encoded by the pulse width modulated waveform supplied by the driver 10.

In general, the buffers 10 and 20 have potentially the same internal topology and comprise an output stage in which output transistors are arranged in a totem pole arrangement so that the output of each buffer can either be connected to the negative supply rail supplied to the buffer, or to the positive supply rail supplied to the buffer. Thus the transistors are driven in anti-phase such that when one is on the other is off and visa versa. In the arrangement shown in Figure 3, a signal to be transmitted across the isolation transformer is supplied to the input terminal IP. An exemplary input signal is shown which is a pulse width modulated signal having a frequency of approximately 6 kHz. The signal can either be in an on state designated "1" or an off state designated "0". The input is supplied to a pulse train generation circuit 30 which generates a pulse train at a frequency (in this example) of about 300 kHz. When the input signal is in the "1" state then the pulse train generator outputs the pulse train, schematically illustrated in Figure 4a, having a mark-space ratio of 20-80 and a frequency of approximately 300 kHz. When the input is in the "0" state then the pulse train generator 30 outputs a signal schematically generated in Figure 4b having a mark-space ratio of 80-20 and a frequency of approximately 300 kHz. Therefore if in this example we assume that the supply voltage is +10 volts then the DC average value of the waveform in Figure 4a is 2 volts and the DC average value of the waveform in Figure 4b is 8 volts.

Looking at the compensation circuit, it can be seen that when the input is in the "1" state the inverter 22 outputs a "0" to the buffer 20 and hence the voltage of the output of the buffer 20 is held at 0 volts. Therefore a voltage of 2 volts appears across the capacitor 6 and it charges to this value.

When the input is in its "0" state then the inverter 22 provides an "1" signal to the buffer 20 and it therefore connects the capacitor to the voltage as determined by the voltage regulator 24.

We know from the earlier explanation of the circuit in the "0" state that the buffer 10 produces a signal which has a DC average of 8 volts. It therefore follows that if the regulator 24 is set to produce a regulator voltage of 6 volts then the voltage occurring across the capacitor will be 2 volts. This is identical to the value that occurs across the capacitor when the signal is in the "1" condition and hence the DC voltage across the capacitor remains invariant irrespective of the state of the input signal. Therefore transitions in the input signal between "0" and "1" do not result in the capacitor 6 having to charge or discharge via the resistance of the primary winding 2.

It is of course possible to add the correction voltage via a summing node at the buffer 10. However this reduces the magnitude of the peak to peak voltage swing of the faster (300 kHz in this example) signal as the sum of this fast signal and the compensation signal must still be within the overall voltage headroom that the buffer can deliver.

Although the above examples have used a 20%-80% duty cycle for the faster waveform, other duty cycles can, of course, be chosen and the compensation voltage needs to be scaled accordingly, to ensure that the compensation voltage is equal to the difference between the DC values of the drive signal from the buffer 10.

As noted before, it is advantageous for the circuitry on the secondary side of the isolation transformer to derive its power from the signal transmitted across the isolation transformer. This means that the power supply for the drive circuitry is not affected by the large voltage fluctuation which might occur on the supply line to the driven device. This adds to the integrity of the control system.

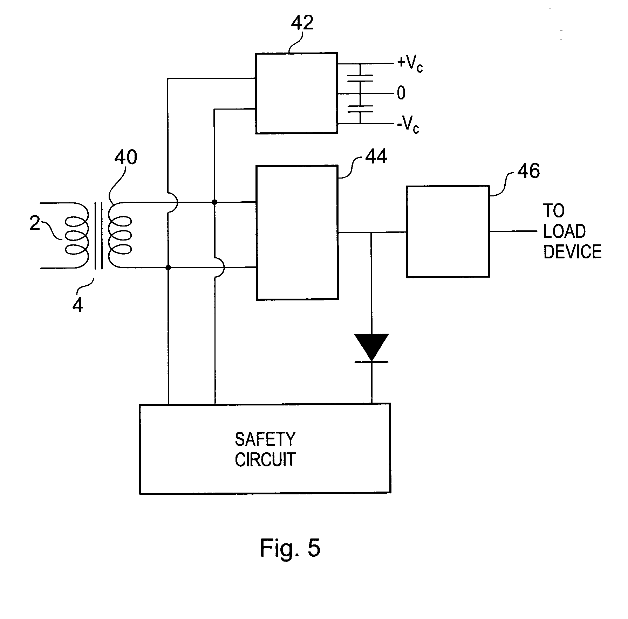

Figure 5 schematically illustrates the circuitry located on the secondary side of the transformer for decoding the control signals and providing a control signal to the power device. A secondary winding 40 of the isolation transformer is connected to a charge pump and voltage regulator 42 which rectifies the drive signal in order to generate positive and negative supply voltages for powering the other components within the control circuit. The secondary winding 40 is also connected to a differential comparator and latch 44 which demodulates the clock signals and determines from them which signal state is being decoded and outputs an appropriate signal to a drive buffer 46 which controls the supply of power to the load device, which typically is a power hungry device such as an actuator.

The output of the circuitry of the transformer is also supplied to a safety circuit which monitors the health of the clock signal provided by the isolation transformer. The safety circuit typically checks to see that the pulses are present and that they are within acceptable amplitude ranges. If these conditions are not satisfied then the safety circuit can provide a short circuit path from the output of the comparator 44 thereby preventing the drive circuit 46 from operating and hence providing power to the load device.

It is thus possible to provide a compensation circuit, and an isolated transformer drive circuit in which masking effects resulting from a transition from one state to another is much reduced.

**Claims**

1. A compensation circuit (18) for use with an isolation device (7) comprising an isolation transformer (4) in series with a capacitor (6), and wherein the isolation device is driven with a drive signal which encodes first and second states, and in the first state the drive signal has a first average value and in the second state the drive signal has a second average value, **characterised by** the compensation circuit (18) comprising a compensation voltage generator (20, 24) for generating a compensation voltage for supply to the isolation device or addition to drive signal so as to hold a DC component of voltage across the capacitor (6) substantially constant.

2. A compensation circuit as claimed in claim 1, **characterised in that** when the drive signal is in the first state the compensation circuit (18) outputs a first compensation voltage.

3. A compensation circuit as claimed in claim 1 or 2, **characterised in that** when the drive signal is in the second state the compensation circuit outputs a second compensation voltage.

4. A compensation circuit as claimed in any one of the preceding claims, **characterised in that** the isolation device (7) is driven in a single ended manner and the compensation voltage is added to the drive signal.

5. A compensation circuit as claimed in any one of claims 1 to 3, **characterised in that** the isolation device (7) is driven in a dual ended manner and the drive signal is supplied to a first input terminal of the isolation device and the compensation voltage is supplied to a second input terminal of the isolation device.

6. A drive for an isolating device, **characterised in that** the isolating device has first and second input terminals and comprises an isolation transformer (4) in series with a capacitor (6), wherein the drive includes a drive device (10) coupled to an input of the isolating device for providing the drive signal, and wherein the drive further includes a compensation circuit (18) as claimed in any one of the preceding claims.

7. A drive as claimed in claim 6, **characterised in that** the drive signal is a pulse train having a first mark-space ratio for encoding the first state and a second mark-space ratio for encoding the second state.

8. A drive as claimed in claim 7, **characterised in that** an input to the drive is in the form of a control signal pulse train, and a frequency of the drive signal is at least an order of magnitude greater than a frequency of the control signal pulse train.

9. A signal transfer system comprising an isolation transformer in series with a capacitor and further including a drive as claimed in any one of claims 6 to 8.

10. A signal transfer system as claimed in claim 9, further including a detection system for decoding the drive signals and for producing a signal for controlling a load, said detection system being coupled to the secondary winding of the isolation transformer and further including a rectifier for rectifying the drive signal received in the secondary winding so as to derive power for the detection system.

11. A method of maintaining a DC voltage across a DC blocking capacitor substantially constant, where the DC blocking capacitor is in series with an isolation transformer and where the isolation transformer is driven with a drive signal that encodes at least first and second states, and in the first state the drive signal has a first average value and in the second state the drive signal has a second average value, the method comprising generating a compensation voltage for supply to the isolation transformer or for addition to the drive signal so as to hold a DC component of voltage across the capacitor substantially constant.

Fig. 1

Fig. 2

Fig. 3

Fig. 4(a)                                                    =1

Fig. 4(b)                                                    =0

Fig. 5